# EUROPEAN PATENT SPECIFICATION

(11) **EP 3 037 876 B1**
(45) Date of publication and mention of the grant of the patent: **17.10.2018**
(21) Application number: 15202763.7
(22) Date of filing: 24.12.2015
(51) Int. Cl.: G02F 1/1345, G02F 1/1362, H05K 1/02, H01L 27/02, H01L 27/12

(54) **SLIM BEZEL AND DISPLAY PROVIDED WITH THE SAME**
SCHMALER RAND UND DAMIT AUSGESTATTETE ANZEIGE
BOÎTIER MINCE ET DISPOSITIF D'AFFICHAGE ASSOCIÉ

(30) Priority: 26.12.2014 CN 201410834739; 26.01.2015 CN 201510038519
(43) Date of publication of application: 29.06.2016
(73) Proprietor: Xiaomi Inc., Beijing 100085 (CN)
(72) Inventor: LIU, Anyu, 100085 BEIJING (CN); LI, Guosheng, 100085 BEIJING (CN); XIAO, Zhengdong, 100085 BEIJING (CN)
(74) Representative: Cougard, Jean-Marie

(56) References cited:
- US-A1- 2011 096 258

## Description

### TECHNICAL FIELD

The present disclosure generally relates to fields of display, and more particularly, to a slim bezel and a display provided with the same.

### BACKGROUND

With increasing display resolution, all major manufacturers of display devote to narrow bezel (or edge) of the display so as to minimize occupation of the bezel on the display.

In related design of the bezel, narrowing has been implemented to upper bezel, left bezel and right bezel. Generally speaking, however, lower bezel of a conventional display is relatively wide since it is typically provided therein with integrated circuit (IC) chips, flexible printed circuit (FPC) bonding, pixel data lines (also referred to as "source lines") and row control logic (also referred to as "Gate In Panel (GIP)") lines, which are used for controlling displaying of the display and layout of which is limited by manufacturing process.

Document US 2011/096258 A1 (28 April 2011) discloses an array substrate for liquid crystal display device including in a particular a gate line and a common line on a substrate, a data drive integrated circuit and data lines crossing the gate line to define a pixel region in a display region.

### SUMMARY

In order to overcome problems existing in related art, there are provided a slim bezel and a display provided with the same. Technical solutions are described as follows.

The invention is defined by the independent claim. Preferred embodiments are defined by the dependent claims.

According to further aspects, there is provided a slim bezel of a display. The slim bezel includes source lines having all a same length, gate in panel GIP lines and at least two customized IC chips, wherein circuit layouts on the customized IC chips are equivalent to a circuit layout on a standard IC chip;
wherein the customized IC chips are arranged in turn laterally in a straight line, and a sum of widths of the customized IC chips in lateral direction is greater than a width of the standard IC chip; and
wherein each of the customized IC chips is connected with at least one of the source lines and the GIP lines.

According to further aspects, every adjacent two of the customized IC chips are connected via a wire, and wherein the customized IC chips are configured to transmit signal simultaneously to all of GIP lines connected with the customized IC chips.

According to further aspects, a sum of areas of the customized IC chips is equal to an area of the standard IC chip.

According to further aspects, a height of each of the customized IC chips is equal to each other and is less than a height of the standard IC chip, and a width of each of the customized IC chips is equal or unequal to each other.

According to further aspects, every adjacent two of the customized IC chips are arranged in contact or in non-contact with each other.

According to further aspects, each of the customized IC chips is provided with pins distributed evenly at upper side of the customized IC chip, and the pins are connected with the source lines and the GIP lines in one-to-one correspondence.

According to further aspects, a surface formed by a width and a height for each of the customized IC chips lies in a same plane; and
the surface formed by the width and the height of each of the customized IC chips is parallel to a surface in which the slim bezel lies; or the surface formed by the width and the height of each of the customized IC chips is perpendicular to the surface in which the slim bezel lies.

According to further aspects, the source lines and the GIP lines connected with the customized IC chips are connected with a corresponding port (26) of a display screen in an arrangement manner of at least one layer.

According to further aspects, there is provided a display provided with a slim bezel. The display includes a display screen and the slim bezel according to the first aspect.

Technical solution according to embodiments of the present disclosure may provide, at least in part, following advantageous effects.

The standard IC chip within the bezel is replaced by at least two customized IC chips laterally arranged side by side. Since a total width of the customized IC chips laterally arranged is greater than a width of the standard IC chip, there can be a greater width occupiable by layout of the source lines and the GIP lines, such that height occupancy thereof can be reduced. Accordingly, it can be solved a problem in related art that the bezel is relatively wide, and narrowing of the bezel of display can be achieved.

It is to be understood that both the foregoing general description and the following detailed description are exemplary and explanatory only and are not restrictive of the present disclosure. The scope of the invention is defined by the appended claims.

### BRIEF DESCRIPTION OF THE DRAWINGS

The accompanying drawings, which are incorporated in and constitute a part of this specification, illustrate embodiments consistent with the present disclosure and, together with the description, serve to explain the principles of the present disclosure.
Fig. 1 is a schematic diagram illustrating an example of a conventional bezel of a display.
Fig. 2A is a block diagram illustrating a front view of a slim bezel of a display according to an example.
Fig. 2B is a block diagram illustrating a perspective view of the slim bezel shown by Fig. 2A, with source lines and GIP lines therein being arranged in a layout of one layer, according to an example.
Fig. 2C is a block diagram illustrating a section view of partial enlarged slim bezel shown by Fig. 2A, according to an example.
Fig. 2D is a block diagram illustrating the slim bezel shown by Fig. 2A, with source lines and GIP lines therein being arranged in a layout of two layers, according to an embodiment.
Fig. 2E is a block diagram illustrating a perspective view of the slim bezel shown by Fig. 2D.
Fig. 2F is a block diagram illustrating a section view of partial enlarged slim bezel shown by Fig. 2D according to an embodiment.
Fig. 3A is a block diagram illustrating a front view of a slim bezel of a display according to another example.
Fig. 3B is a block diagram illustrating a section view of partial enlarged slim bezel shown by Fig. 3A, according to an example.
Fig. 3C is a block diagram illustrating the slim bezel shown by Fig. 3A, with source lines and GIP lines therein being arranged in a layout of two layers, according to an embodiment.
Fig. 3D is a block diagram illustrating a section view of partial enlarged slim bezel shown by Fig. 3C, according to an exemplary embodiment.
Fig. 4 is a block diagram illustrating a front view of a slim bezel of a display according to still another example.
Fig. 5 is a block diagram illustrating a display provided with a slim bezel, according to an example.

### DETAILED DESCRIPTION

Reference will now be made in detail to exemplary examples and embodiments which are illustrated in the accompanying drawings. The following description refers to the accompanying drawings in which the same numbers in different drawings represent the same or similar elements unless otherwise represented. The implementations set forth in the following description of exemplary embodiments do not represent all implementations consistent with the present disclosure. Instead, they are merely examples of apparatuses and methods consistent with aspects related to the present disclosure as recited in the appended claims. The "slim bezel" mentioned herein generally refers to a narrowed lower bezel of a display which includes at least a display screen and the lower bezel.

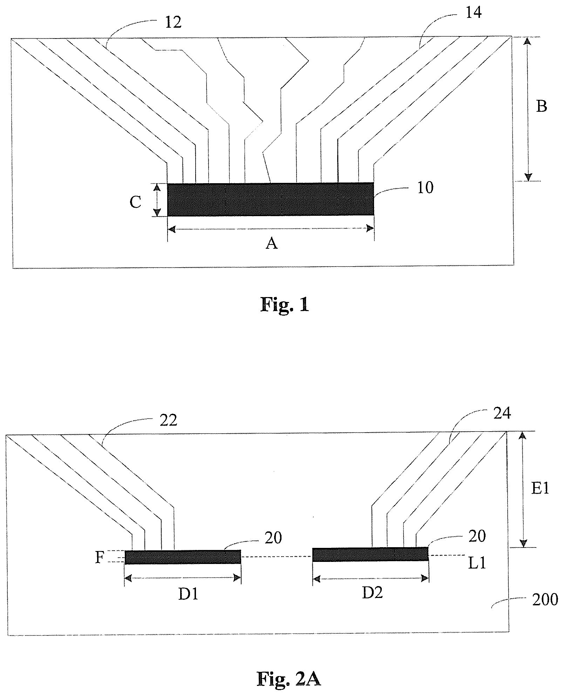

Reference may be made to Fig. 1, which is a schematic diagram illustrating an example of a conventional bezel of a display. In the bezel shown by Fig. 1, a standard IC chip 10 may have a height C and a width A. The bezel is also provided with source lines 12 and GIP lines 14. In general, the number of GIP lines 14 is far less than that of source lines 12, and a relatively high level of synchronous transmission is required by the source lines 12 for signal transmission. Thus, a layout of the source lines 12 needs to be paid more attention to. For a high definition display screen made from a-Si and indium gallium zinc oxide (IGZO), each source line 12 or each GIP line 14 is connected with a pin of the standard IC chip 10. For a display screen with a resolution of 1280*1024, since each pixel is formed by three transistors (corresponding to three colors of red, green, and blue, respectively) and one source line is required for each column, there are 1280*3=3840 source lines to be arranged in a limited width. Even for adoption of low temperature poly-silicon (LTPs) with mux circuit, there are about 1280 source lines to be required.

Therefore, a certain height needs to be occupied by the source lines connected from a limited width A into the display panel. Moreover, for displaying of the display, pixels connected with the source lines 12 need to be kept in synchronization during the displaying. In other words, the source lines 12 are required to be formed in a same length. Accordingly, a greater height B is to be occupied, so the lower bezel of the display is relatively wide.

With limitation of conventional manufacturing process, it is hard to provide IC chips with less width and greater length. However, it is possible to provide IC chips with less length and less width. Therefore, in order to reduce a width of the lower bezel of the display as much as possible, the standard IC chip may be replaced by at least two customized IC chips with less length and less width, as shown in Fig. 2A.

Fig. 2A is a block diagram illustrating a front view of a slim bezel of a display according to an example. In Fig. 2A, the slim bezel 200 includes at least two customized IC chips 20, source lines 22 having all a same length, and GIP lines 24, wherein circuit layouts on the customized IC chips 20 are equivalent to a circuit layout on a standard IC chip.

The customized IC chips 20 are arranged in turn laterally in a straight line L1, and a sum of widths of the customized IC chips 20 in lateral direction is greater than a width of the standard IC chip. For two customized IC chips 20 as shown in Fig. 2A, a sum of widths, D1+D2, of the two customized IC chips 20 is typically greater than a width, A, of the standard IC chip 10 as shown in Fig. 1.

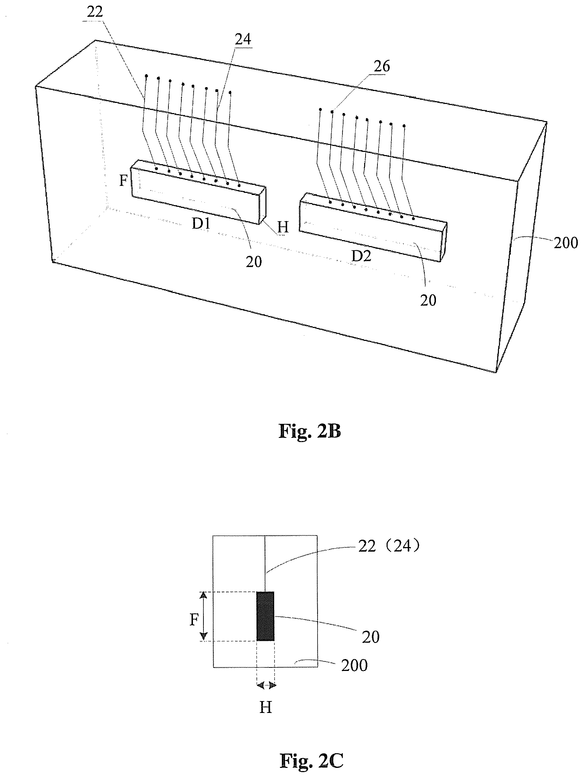

The customized IC chips 20 are arranged in a same manner. In other words, a surface formed by a width and a height for each of the customized IC chips lies in a same plane; and a layout direction of the customized IC chips is provided in a first layout manner such that the surface formed by the width and the height of each of the customized IC chips is parallel to a surface in which the slim bezel lies. Referring to Fig. 2B, which is a block diagram illustrating a perspective view of the slim bezel shown by Fig. 2A, with source lines and GIP lines therein being arranged in a layout of one layer, the customized IC chip 20 at left side and the customized IC chip 20 at right side are arranged in a same manner. In other words, a surface formed by a width D1 and a height F of the customized IC chip 20 at left side, and a surface formed by a width D2 and a height F of the customized IC chip 20 at right side lie in a same plane, and are parallel to a surface in which the slim bezel 200 lies. A line in which a thickness H of the customized IC chip 20 lies is perpendicular to the surface in which the slim bezel 200 lies.

Reference now may be further made to Fig. 2C, which is a block diagram illustrating a section view of partial enlarged slim bezel shown by Fig. 2A. As can be seen from the drawing, a surface formed by a width and a height F of the customized IC chip 20 is parallel to a surface in which the slim bezel 200 lies, a thickness H of the customized IC chip 20 lies is perpendicular to the surface in which the slim bezel 200 lies, and the surface in which the slim bezel 200 lies is the same as or parallel to a surface in which the display screen of the display lies.

Alternatively, every adjacent two of the customized IC chips 20 are arranged in contact or in non-contact with each other. In other words, a distance between the adjacent two of the customized IC chips 20 is greater than or equal to 0. When every adjacent two of the customized IC chips 20 are arranged in contact with each other, the sum of widths of the customized IC chips 20 is greater than the width of the standard IC chip. Otherwise, when every adjacent two of the customized IC chips 20 are arranged in non-contact with each other, that is, when there is a certain distance between every adjacent two of the customized IC chips 20, a distance from the leftmost one of the customized IC chips 20 to the rightmost one of the customized IC chips 20 is typically greater than the width A of the standard IC chip 10 as shown in Fig. 1.

In order to reduce a height occupied by the customized IC chips in longitudinal direction so as to narrow the lower bezel of the display as much as possible, the customized IC chips 20 may be arranged in turn laterally in a straight line, that is, laterally central lines of the customized IC chips 20 may lie in a straight line L1. However, it is an idealized state that the central lines of the customized IC chips 20 lie in the straight line L1. As an actual arrangement, the customized IC chips 20 are arranged in turn laterally in the straight line as much as possible.

Since the circuit layouts on the customized IC chips 20 are equivalent to the circuit layout on the standard IC chip, that is, the circuitry on the standard IC chip is distributed onto the customized IC chips 20, a sum of widths of the customized IC chips 20 in lateral direction may be set as greater than the width of the standard IC chip, so as to reduce the height occupied by layout of the source lines 22 and the GIP lines 24 as much as possible. A fixed area may be occupied by the layout of the source lines 22 and the GIP lines 24. Therefore, if there is a greater width occupiable by the area of the layout, the height occupied by the layout of the source lines 22 and the GIP lines 24 may be smaller. As shown in Fig. 2A, a height E1 is smaller than the height B in Fig. 1. In this way, the lower bezel of the display has a reduced width, and thus is narrowed.

For implementation of narrowing the lower bezel of the display, each of the customized IC chips 20 is connected with at least one of the source lines 22 and the GIP lines 24. In other words, a customized IC chip 20 may be connected only with a source line 22, also may be connected only with a GIP line 24, and may be connected with both a source line 22 and a GIP line 24, depending on internal circuit layout of the customized IC chip 20.

Alternatively, each of the customized IC chips 20 is provided with pins distributed evenly at upper side thereof, and those pins are connected with the source lines 22 and the GIP lines 24 in one-to-one correspondence. In generally, number of the pins at upper side of the customized IC chips 20 is equal to that of the source lines 22 and the GIP lines 24. According to actual needs, however, there may be pins for other purposes provided at upper side of the customized IC chips 20.

As each of the customized IC chips 20 is provided with pins distributed evenly at upper side thereof, and those pins are connected with the source lines 22 and the GIP lines 24 in one-to-one correspondence, a waste of area for the layout of the source lines 22 and the GIP lines 24 at upper side of the customized IC chips 20 may be reduced as much as possible. Thus, the source lines 22 and the GIP lines 24 may be distributed as evenly as possible such that reduction of a height E1 for layout in Fig. 2A may be maximized.

In a possible implementation manner, as there are certain requirements for displaying of pixels in the display screen, that is, those pixels need to be displayed on or displayed off simultaneously, there is a high demand on timeliness for the pixels. Accordingly, lengths of the source lines 22 need to be provided as equal to each other. In order to enable the pixels to be controlled at the same time, provided that the lengths of the source lines 22 are equal to each other, every adjacent two of the customized IC chips 20 may be connected via a wire, such that the customized IC chips 20 may be able to transmit signal to the source lines 22 connected thereto simultaneously, so as to control the source lines 22 at the same time.

Moreover, since circuitries on the customized IC chips 20 are obtained through distribution of the circuitry of the standard IC chip onto the customized IC chips 20, and various components in the circuitries occupy a constant layout space, a sum of areas of the customized IC chips is typically equal to an area of the standard IC chip. Alternatively, in view of area loss at edges of the customized IC chips 20, the sum of areas of the customized IC chips 20 may be slightly larger than the area of the standard IC chip.

Alternatively, heights F of the customized IC chips 20 may be equal to each other. Since circuitries on the customized IC chips 20 are obtained through distribution of the circuitry of the standard IC chip onto the customized IC chips 20, if the sum of areas of the customized IC chips is equal to the area of the standard IC chip, the height F of the customized IC chips 20 is less than the height C of the standard IC chip in Fig. 1. However, widths of the customized IC chips may be equal to or unequal to each other. For example, D1 may be equal to or unequal to D2.

In a possible implementation manner, in order to further narrow the lower bezel of the display, the source lines and the GIP lines connected with the customized IC chips may be connected with a corresponding port of the display screen in an arrangement manner of two or more layers.

In Figs. 2A, 2B and 2C, the source lines and the GIP lines connected with the customized IC chips are connected with the corresponding port of the display screen in an arrangement manner of one layer, that is, all the source lines and the GIP lines lie in a same layer. However, with an excessive amount of the source lines, in order to further reduce height occupancy of those source lines in the lower bezel, the former one or both of the source lines and the GIP lines are arranged in at least two layers, according to an embodiment. For example, as shown in Fig. 2B, part of the source lines 22 and the GIP lines 24 may be arranged evenly in a first layer and connected with the corresponding port 26 on the display screen, while the remain part of the source lines 22 and the GIP lines 24 may be arranged evenly in a second layer and connected with the corresponding port 26 on the display screen.

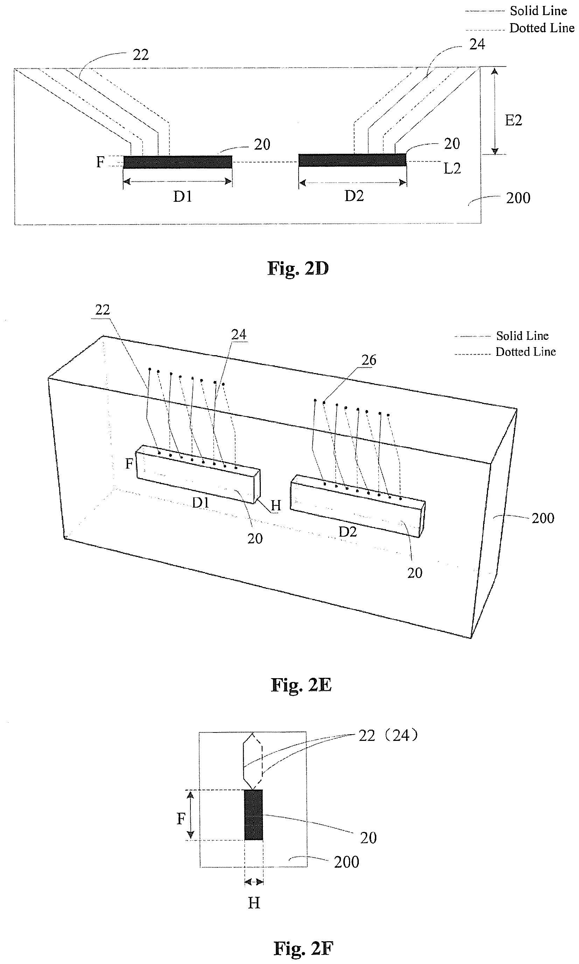

Reference may be made to Fig. 2D, which is a block diagram illustrating the slim bezel shown by Fig. 2A, with source lines and GIP lines therein being arranged in a layout of two layers, according to an embodiment. In Fig. 2D, lines indicated by solid lines among the source lines 22 and the GIP lines 24 lie in the first layer, while lines indicated by dotted lines lie in the second layer. For clear illustration of those two layers, as shown in Fig. 2E, which is a block diagram illustrating a perspective view of the slim bezel shown by Fig. 2D, the lines indicated by solid lines and the lines indicated by dotted lines among the source lines 22 and the GIP lines 24 lie in two layers, respectively, but the customized IC chips 20 and the pin provided thereon are the same as that shown in Figs. 2A and 2B.

Reference now may be further made to Fig. 2F, which is a block diagram illustrating a section view of partial enlarged slim bezel shown by Fig. 2D according to an embodiment. The source lines 22 and the GIP lines 24 lying in two layers respectively are connected with the customized IC chips 20 and corresponding ports of the display screen. A surface formed by the width and the height F of the customized IC chips 20 is parallel to a surface in which the slim bezel lies, while the thickness H of the customized IC chips 20 is perpendicular to the surface in which the slime bezel lies.

As can be seen from Fig. 2B and 2E, layouts of the source lines 22 and the GIP lines 24 in Fig. 2B lie in a same layer, while layouts of the source lines 22 and the GIP lines 24 in Fig. 2E lie in two layers. Since a thickness of the lower bezel may be occupied when the layouts of the source lines 22 and the GIP lines 24 in Fig. 2E lie in two layers, there may be a reduced amount of circuitry lines in one layer such that layout area occupancy of the layer can be reduced. Thus, with a fixed width for each layer, height occupancy of the circuitry lines for the each layer can be reduced, that is, height occupancy in the lower bezel can be reduced and the lower bezel can be further narrowed. For example, layout height E2 in Fig. 2D is less than layout height E1 in Fig. 2A. Thus a straight line L2 in which central lines of the customized IC chip 20 at left side and the customized IC chip 20 at right side in Fig. 2D lie differs from the straight line L1 in Fig. 2A. Furthermore, L2 is located closer to upper edge of the lower frame 200, that is, closer to the display screen of the display than L1.

To sum up, according to the slim bezel of display provided by the embodiments of the present disclosure, the standard IC chip within the bezel is replaced by at least two customized IC chips laterally arranged side by side. Since a total width of the customized IC chips laterally arranged is greater than a width of the standard IC chip, there can be a greater width occupiable by layout of the source lines and the GIP lines, such that height occupancy thereof can be reduced. Accordingly, it can be solved a problem in related art that the bezel is relatively wide, and narrowing of the bezel of display can be achieved.

In an alternative implementation manner, in order to reduce width occupancy of a width of the customized IC chips in lower bezel of the display as much as possible, that is, to further narrow the lower bezel of the display, a layout direction of the customized IC chips may be also provide in a second layout manner during design of the lower bezel such that the customized IC chips are provided perpendicular to the surface in which the display screen lies. In other words, the customized IC chips are arranged in a same manner, wherein the thickness of the lower bezel of the display is occupied by widths of the customized IC chips, while the width of the lower bezel of the display is occupied by thicknesses of the customized IC chips. That is, surfaces formed by widths and heights of the customized IC chips lie in a same plane, and a surface formed by the width and the height of each of the customized IC chips is perpendicular to the surface in which the slim bezel lies.

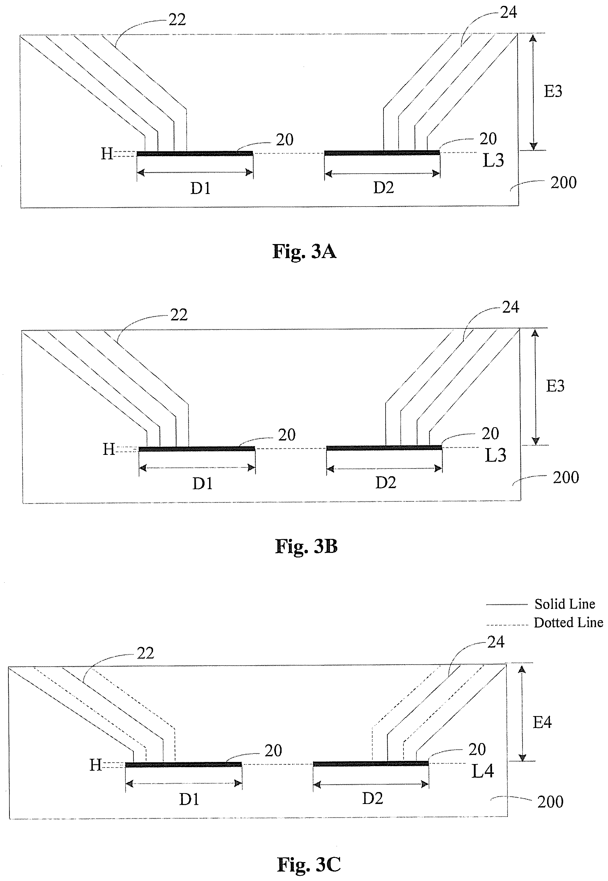

Reference now may be made to Fig. 3A, which is a block diagram illustrating a front view of a slim bezel of a display according to another example. As shown in Fig. 3A, the customized IC chips 20 provided within the lower bezel 200 of the display are still laterally arranged in a straight line L3, and the customized IC chips 20 are provided as perpendicular to the surface in which the display screen lies, that is, the customized IC chips 20 is provided at 90°to the standard IC chip 10 in Fig. 1. Since a thickness H of the customized IC chips 20 is far less than a width (i.e. the width F in Fig. 2A) thereof, the lower bezel of the display can be narrowed. For clear illustration of difference between Fig. 3A and Fig. 2A, reference may be now made to Fig. 3B, which is a block diagram illustrating a section view of partial enlarged slim bezel shown by Fig. 3A, according to an example. As shown in Fig. 3B, a height of the lower bezel 200 is occupied by the thickness H of the customized IC chips 20, while a thickness of the lower bezel 200 is occupied by the height F of the customized IC chips 20. As can be seen from Fig. 3B and 2C, the thickness H of the customized IC chips 20 is far less than the height F of the customized IC chips 20. Accordingly, height occupancy of the customized IC chips 20 in the lower bezel 200 can be reduced, thus the lower bezel of the display is narrowed.

Similarly, when the customized IC chips 20 are arranged as shown in Fig. 3A, in order to further narrow the lower bezel, the source lines and the GIP lines connected with the customized IC chips are connected with a corresponding port of the display screen in an arrangement manner of two or more layers, according to an embodiment.

In Fig. 3A, the source lines and the GIP lines connected with the customized IC chips are connected with the corresponding port of the display screen in an arrangement manner of one layer, that is, all the source lines and the GIP lines lie in a same layer. However, with an excessive amount of the source lines, in order to further reduce height occupancy of those source lines in the lower bezel, the former one or both of the source lines and the GIP lines are arranged in at least two layers, according to an embodiment. For example, part of the source lines and the GIP lines may be arranged evenly in a first layer and connected with the corresponding port on the display screen, while the remain part of the source lines and the GIP lines may be arranged evenly in a second layer and connected with the corresponding port on the display screen.

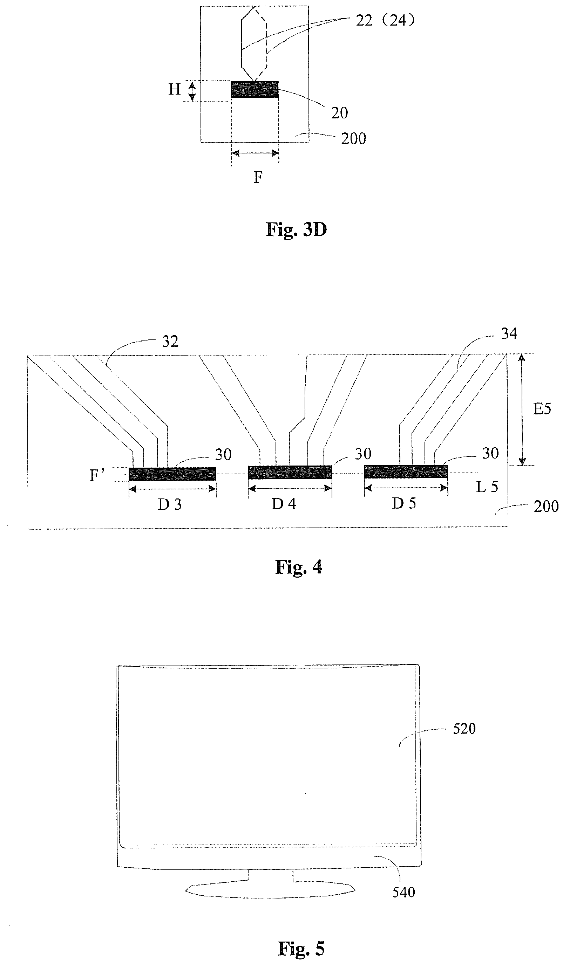

Reference may be made to Fig. 3C, which is a block diagram illustrating the slim bezel shown by Fig. 3A, with source lines and GIP lines therein being arranged in a layout of two layers, according to an exemplary embodiment. In Fig. 3C, lines indicated by solid lines among the source lines 22 and the GIP lines 24 arranged within the lower bezel 200 lie in the first layer, while lines indicated by dotted lines lie in the second layer. Layout of remaining part within the lower bezel 200 and configuration thereof are the same as that in Fig. 3A, details of which may refer to description of Fig. 3A. For clear illustration of those two layers, further reference may be made to Fig. 3D, which is a block diagram illustrating a section view of partial enlarged slim bezel shown by Fig. 3C, according to an embodiment. The source lines 22 and the GIP lines 24 lying in two layers respectively within the lower bezel 200 are connected with the customized IC chips 20 and a corresponding port of the display screen, wherein a height of the lower bezel 200 is occupied by the thickness H of the customized IC chips 20, while a thickness of the lower bezel 200 is occupied by the height F of the customized IC chips 20.

As can be seen from Fig. 3B and 3D, layouts of the source lines 22 and the GIP lines 24 in Fig. 3B lie in a same layer, while layouts of the source lines 22 and the GIP lines 24 in Fig. 3D lie in two layers. Since a thickness of the lower bezel may be occupied when the layouts of the source lines 22 and the GIP lines 24 in Fig. 2E lie in two layers, there may be a reduced amount of circuitry lines in one layer such that layout area occupancy of the layer can be reduced. Thus, with a fixed width for each layer, height occupancy of the circuitry lines for the each layer can be reduced, that is, height occupancy in the lower bezel can be reduced and the lower bezel can be further narrowed. For example, a height E4 in Fig. 3C is less than a height E3 in Fig. 3A. thus a straight line L4 in which central lines of the customized IC chip 20 at left side and the customized IC chip 20 at right side in Fig. 3C lie differs from the straight line L3 in Fig. 3A. Furthermore, L4 is located closer to upper edge of the lower frame 200, that is, closer to the display screen of the display than L3.

To sum up, according to the slim bezel of display, the standard IC chip within the bezel is replaced by at least two customized IC chips laterally arranged side by side. Since a total width of the customized IC chips laterally arranged is greater than a width of the standard IC chip, there can be a greater width occupiable by layout of the source lines and the GIP lines, such that height occupancy thereof can be reduced. Accordingly, it can be solved a problem in related art that the bezel is relatively wide, and narrowing of the bezel of display can be achieved.

It should be further noted that, for the structure of the lower bezel as shown in Fig. 3A, the structure as shown in Fig. 2A is applicable therein except difference of arrangement direction of the customized IC chips between Fig. 3A and Fig. 2A. Detailed structure of them may also refer to description of Fig. 2A and is omitted herein.

Moreover, it should be noted that, there are 2 customized IC chips 20 with less length and less width than illustrated in Figs. 2A and 3A. According to actual needs, however, the standard IC chip may be divided into 3 or more customized IC chips with less length and less width. Reference may be made to Fig. 4, which is a block diagram illustrating a front view of a slim bezel of a display according to still another example. As shown in Fig. 4, the standard IC chip is divided into 3 customized IC chips 30 with less length and less width. Those customized IC chips 30 obtained through division are arranged in turn laterally in a straight line L5. A total area of the customized IC chips 30 is equal to an area of the standard IC chip 10, a total width of the customized IC chips 30 is greater to a width A of the standard IC chip 10, and a height F' of the customized IC chips 30 is less than a height C of the standard IC chip 10. The customized IC chips 30 are also provided with pins distributed evenly at upper side thereof, and the pins are connected with the source lines 32 and the GIP lines 34 one by one. Similarly, a layout height E5 as shown in Fig. 4 is smaller than the layout height B as shown in Fig. 1. In other words, the lower bezel of the display is narrowed.

To sum up, according to the slim bezel of display, the standard IC chip within the bezel is replaced by at least two customized IC chips laterally arranged side by side. Since a total width of the customized IC chips laterally arranged is greater than a width of the standard IC chip, there can be a greater width occupiable by layout of the source lines and the GIP lines, such that height occupancy thereof can be reduced. Accordingly, it can be solved a problem in related art that the bezel is relatively wide, and narrowing of the bezel of display can be achieved.

Fig. 5 is a block diagram illustrating a display provided with a slim bezel, according to an example. As shown in Fig. 5, the display includes a display screen 520 and a slim bezel 540. The slim bezel 540 is implemented as the slim bezel as shown by Figs. 2A-2F, Fig. 3A-3D, or Fig. 4, details of which may refer to the description of Figs. 2A-2F, Fig. 3A-3D, or Fig. 4 and may be omitted herein.

To sum up, according to the slim bezel of display, the standard IC chip within the bezel is replaced by at least two customized IC chips laterally arranged side by side. Since a total width of the customized IC chips laterally arranged is greater than a width of the standard IC chip, there can be a greater width occupiable by layout of the source lines and the GIP lines, such that height occupancy thereof can be reduced. Accordingly, it can be solved a problem in related art that the bezel is relatively wide, and narrowing of the bezel of display can be achieved.

Furthermore, it should be noted that, terms "height" "width" and "thickness" in the description of the customized IC chips are used base on illustration of those drawings described above. For a same customized IC chip, a value of the width thereof is greater than a value of the height thereof which is greater than a value of the thickness thereof. Accordingly, terms "height", "width" and "thickness" in the description of the customized IC chips are used only for purpose of easy description, rather than limiting protection scope of the present disclosure. According to actual application, "height" of the customized IC chip may be also referred to as "width", while "width" thereof may be also referred to as "length".

Other embodiments of the invention will be apparent to those skilled in the art from consideration of the specification and practice of the invention disclosed here. This application covers any variations, uses, or adaptations of the invention which fall within the scope of the appended claims. It is intended that the specification and examples be considered as exemplary only, with the scope of the invention being defined by the appended claims.

It will be appreciated that the present invention is not limited to the exact construction that has been described above and illustrated in the accompanying drawings, and that various modifications and changes can be made as long as they fall within the scope of the appended claims.

## Claims

1. A slim bezel (200, 540) of a display, the slim bezel comprises:
- source lines (22, 32) having al the same length,
- gate in panel lines (24, 34); and
- at least two customized IC chips (20, 30), wherein a circuitry is distributed onto said at least two customized IC chips for controlling displaying of a display screen via the source lines and gate in panel lines;
the customized IC chips being arranged in turn laterally in a straight line;
wherein each of the customized IC chips is connected with at least one of the source lines and gate in panel lines;
wherein all lines among the source lines and the gate in panel lines lie in at least two separate layers and connect the customized IC chips with a corresponding port (26) of the display scree; wherein each of the customized IC chips is provided with pins distributed evenly at an upper side of the customized IC chip, and the pins are connected with the source lines and the gate in panel lines in one-to-one correspondence;
said source lines having all a same length between the corresponding customized IC chip and the display screen.

2. The slim bezel of claim 1, **characterized in that** every adjacent two of the customized IC chips are connected via a wire such that the customized IC chips are configured to transmit signal simultaneously to the gate in panel lines connected with the customized IC chips.

3. The slim bezel of claim 1 or 2, **characterized in that** every adjacent two of the customized IC chips contact each other.

4. The slim bezel of claim 1 or 2, **characterized in that** every adjacent two of the customized IC chips are spaced apart from each other along the straight line.

5. The slim bezel of any one of claims 1 to 4, **characterized in that** each of the customized IC chips lies in a same first plane; said first plane being parallel to a second plane in which lies the slim bezel.

6. The slim bezel of any one of claims 1 to 4, **characterized in that** each of the customized IC chips lies in a same first plane; said first plane being perpendicular to a second plane in which lies the slim bezel.

7. A display provided with a slim bezel, **characterized in that** the display comprises a display screen (520) and the slim bezel (540) according to anyone of claims 1-6.

## Patentansprüche

1. Schlanke Einfassung (200, 540) eines Displays, wobei die schlanke Einfassung umfasst:
- Quellzeilen (22, 32), die alle dieselbe Länge aufweisen,
- Tor-in-Paneel-Zeilen (24, 34) und
- mindestens zwei angepasste IC-Chips (20, 30), wobei eine Schaltung zum Steuern des Anzeigens eines Displaybildschirms über die Quellzeilen und die Tor-in-Paneel-Zeilen auf die mindestens zwei angepassten IC-Chips verteilt ist,
wobei die angepassten IC-Chips seitlich abwechselnd in einer geraden Linie angeordnet sind,
wobei jeder der angepassten IC-Chips mit mindestens einer der Quellzeilen und der Tor-in-Paneel-Zeilen verbunden ist,
wobei alle Zeilen der Quellzeilen und den Tor-in-Paneel-Zeilen in mindestens zwei separaten Schichten liegen und die angepassten IC-Chips mit einem entsprechenden Anschluss (26) des Displaybildschirms verbinden,
wobei jeder der angepassten IC-Chips mit Stiften versehen ist, die auf einer Oberseite des angepassten IC-Chips gleichmäßig verteilt sind, und die Stifte in einer Eins-zu-eins-Entsprechung mit den Quellzeilen und den Tor-in-Paneel-Zeilen verbunden sind,
wobei die Quellzeilen zwischen dem entsprechenden angepassten IC-Chip und dem Displaybildschirm alle eine selbe Länge aufweisen.

2. Schlanke Einfassung nach Anspruch 1, **dadurch gekennzeichnet, dass** jeweils zwei benachbarte der angepassten IC-Chips über einen Draht derart verbunden sind, dass die angepassten IC-Chips dazu ausgelegt sind, ein Signal an die Tor-in-Paneel-Zeilen, die mit den angepassten IC-Chips verbunden sind, gleichzeitig zu übertragen.

3. Schlanke Einfassung nach Anspruch 1 oder 2, **dadurch gekennzeichnet, dass** jeweils zwei benachbarte der angepassten IC-Chips einander berühren.

4. Schlanke Einfassung nach Anspruch 1 oder 2, **dadurch gekennzeichnet, dass** jeweils zwei benachbarte der angepassten IC-Chips entlang der geraden Linie voneinander beabstandet sind.

5. Schlanke Einfassung nach einem der Ansprüche 1 bis 4, **dadurch gekennzeichnet, dass** jeder der angepassten IC-Chips in einer selben ersten Ebene liegt, wobei die erste Ebene parallel zu einer zweiten Ebene, in der die schlanke Einfassung liegt, verläuft.

6. Schlanke Einfassung nach einem der Ansprüche 1 bis 4, **dadurch gekennzeichnet, dass** jeder der angepassten IC-Chips in einer selben ersten Ebene liegt, wobei die erste Ebene senkrecht zu einer zweiten Ebene, in der die schlanke Einfassung liegt, steht.

7. Display, das mit einer schlanken Einfassung versehen und **dadurch gekennzeichnet ist, dass** das Display einen Displaybildschirm (520) und die schlanke Einfassung (540) nach einem der Ansprüche 1 - 6 umfasst.

## Revendications

1. Cadre mince (200, 540) d'un afficheur, le cadre mince comprenant :
- des lignes de source (22, 32) ayant toutes la même longueur,
- des lignes de grille dans le panneau (24, 34) ; et
- au moins deux puces de circuit intégré personnalisées (20, 30), dans lequel des éléments de circuit sont répartis sur lesdites au moins deux puces de circuit intégré personnalisées pour commander l'affichage d'un écran d'affichage par l'intermédiaire des lignes de source et des lignes de grille dans le panneau ;
les puces de circuit intégré personnalisées étant agencées à leur tour latéralement en ligne droite ;
dans lequel chacune des puces de circuit intégré personnalisées est connectée à au moins l'une des lignes de source et des lignes de grille dans le panneau ;
dans lequel toutes les lignes parmi les lignes de source et les lignes de grille dans le panneau se trouvent dans au moins deux couches séparées et connectent les puces de circuit intégré personnalisées à un port (26) correspondant de l'écran d'affichage ;
dans lequel chacune des puces de circuit intégré personnalisées est pourvue de broches réparties uniformément d'un côté supérieur de la puce de circuit intégré personnalisée, et les broches sont connectées aux lignes de source et aux lignes de grille dans le panneau dans une correspondance biunivoque ;
lesdites lignes de source ayant toutes une même longueur entre la puce de circuit intégré personnalisée correspondante et l'écran d'affichage.

2. Cadre mince selon la revendication 1, **caractérisé en ce que** toutes les deux puces adjacentes parmi les puces de circuit intégré personnalisées sont connectées par l'intermédiaire d'un fil de sorte que les puces de circuit intégré personnalisées sont configurées pour transmettre un signal simultanément aux lignes de grille dans le panneau connectées aux puces de circuit intégré personnalisées.

3. Cadre mince selon la revendication 1 ou 2, **caractérisé en ce que** toutes les deux puces adjacentes parmi les puces de circuit intégré personnalisées sont en contact l'une avec l'autre.

4. Cadre mince selon la revendication 1 ou 2, **caractérisé en ce que** toutes les deux puces adjacentes parmi les puces de circuit intégré personnalisées sont espacées l'une de l'autre le long de la droite.

5. Cadre mince selon l'une quelconque des revendications 1 à 4, **caractérisé en ce que** chacune des puces de circuit intégré personnalisées se trouve dans un même premier plan ; ledit premier plan étant parallèle à un deuxième plan dans lequel se trouve le cadre mince.

6. Cadre mince selon l'une quelconque des revendications 1 à 4, **caractérisé en ce que** chacune des puces de circuit intégré personnalisées se trouve dans un même premier plan ; ledit premier plan étant perpendiculaire à un deuxième plan dans lequel se trouve le cadre mince.

7. Afficheur pourvu d'un cadre mince, **caractérisé en ce que** l'afficheur comprend un écran d'affichage (520) et le cadre mince (540) selon l'une quelconque des revendications 1 à 6.
